Europäisches Patentamt

European Patent Office

Office européen des brevets

(11) Numéro de publication: **0 151 077**
A2

# DEMANDE DE BREVET EUROPEEN

(21) Numéro de dépôt: 85400126.0

(22) Date de dépôt: 25.01.85

(51) Int. Cl.⁴: **G 09 G 3/36**, G 11 C 8/00

(30) Priorité: **31.01.84 FR 8401479**

(43) Date de publication de la demande: **07.08.85**
**Bulletin 85/32**

(84) Etats contractants désignés: **DE FR GB IT**

(71) Demandeur: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Bisotto, Sylvette, 3 rue Bach Le Fontanil-Cornillon, F-38120 Saint Egreve (FR)**
Inventeur: **Blanc, Jean-Philippe, 50, rue Jean-Jacques Rousseau, F-38400 Saint Martin d'Heres (FR)**
Inventeur: **Bodin, Bernard, 31, Le Plaçage, F-38360 Sassenage (FR)**
Inventeur: **Poujois, Robert, Les Jaillets, F-38650 Sinard (FR)**

(74) Mandataire: **Mongrédien, André et al, c/o BREVATOME 25, rue de Ponthieu, F-75008 Paris (FR)**

(54) Circuit d'adressage d'un imageur matriciel comportant des registres à décalage formés de mémoires statiques et procédé d'adressage avec un tel circuit.

(57) Circuit d'adressage d'un imageur matriciel comportant des registres à décalage formés de mémoires statiques et procédé d'adressage avec un tel circuit.

Pour un imageur à p colonnes, le circuit comprend p points de registre formés de mémoires statiques ($M_i$), une première série de commutateurs ($C_1$) placés devant les points de registre $M_{k-1}$, k étant un nombre pair allant de 1 à p, une seconde série de commutateurs ($C_2$) placés devant les points de registre $M_k$, et une horloge de transfert (13) engendrant un premier signal ($\varphi_1$) commandant la première série de commutateurs, afin d'assurer le chargement d'un signal « 1 » dans le point de registre ($M_1$) et le transfert du contenu du point de registre $M_k$ au point de registre $M_{k+1}$, et un second signal ($\varphi_2$) commandant la seconde série de commutateurs, afin d'assurer le transfert du contenu du point de registre $M_{k-1}$ au point de registre $M_k$.

EP 0 151 077 A2

Circuit d'adressage d'un imageur matriciel comportant
des registres à décalage formés de mémoires statiques
et procédé d'adressage avec un tel circuit

La présente invention concerne un circuit d'adressage d'un imageur matriciel comportant des registres à décalage formés de mémoires statiques et un procédé d'adressage utilisant un tel circuit. Elle s'applique notamment pour l'adressage d'un imageur matriciel à cristal liquide utilisé pour la visualisation d'images et/ou de caractères alphanumériques.

Dans un imageur matriciel, l'adressage des points élémentaires d'affichage des lignes et des colonnes de l'imageur est réalisé au moyen de deux registres à décalage, un registre "ligne" et un registre "colonne" appelé aussi registre vidéo.

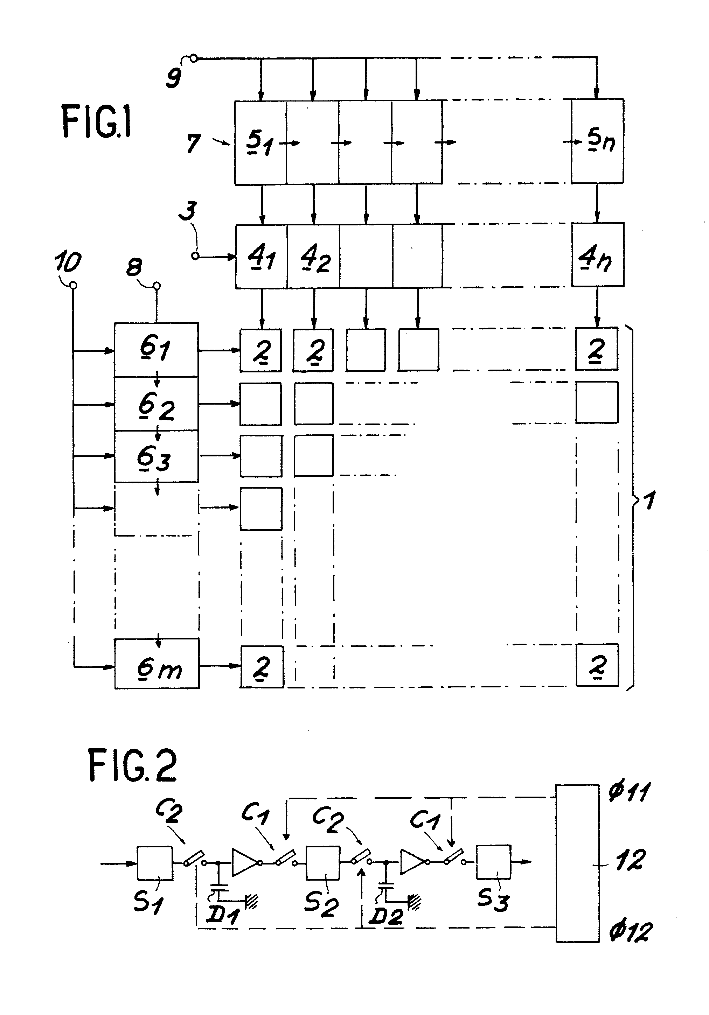

Sur la figure 1, on a représenté schématiquement et de façon simplifiée un imageur matriciel équipé de ses circuits de commande.

Cet imageur comprend un écran d'affichage 1 formé de points élémentaires d'affichage 2 disposés sous forme d'une matrice de m lignes et n colonnes. Ces points élémentaires comportent chacun un condensateur, dont le diélectrique est du cristal liquide, commandé par un transistor en transistor planaire.

Cet imageur comprend aussi n mémoires analogiques $4_1$, ..., $4_n$, constituées chacune d'un condensateur, dans lesquelles est stocké le signal vidéo 3 échantillonné. L'échantillonnage du signal vidéo, dans les mémoires analogiques, est commandé par le registre à décalage "colonne" comportant n points de registre $5_1$, ..., $5_n$, un point de registre par colonne. Ce registre "colonne" est un registre à écriture série et lecture parallèle.

L'adressage des mémoires analogiques $4_1$, ..., $4_n$ est réalisé par un signal 7 appliqué sur l'en-

0151077

trée du point de registre $5_1$ du registre à décalage "colonne". Ce signal est un signal "1" qui est transféré successivement dans les points de registre $5_2$, ..., $5_n$ par des signaux d'horloge 9 ; la mémoire analogique $4_i$ adressée, où $1 \leq i \leq n$, est celle dont le point de registre $5_i$ associé contient le signal "1".

Etant donné que les mémoires analogiques $4_1$, ...,$4_n$ sont constituées par des condensateurs de capacité faible, celles-ci sont chargées à chaque instant à la valeur présente du signal vidéo 3. Par ailleurs, les points de registre "colonne" servent à connecter ces condensateurs sur le signal vidéo 3 et à les déconnecter au moment précis où l'échantillon doit être prélevé. Les mémoires analogiques $4_1$, ...,$4_n$ sont donc chargées par la dernière valeur du signal vidéo reçue avant leur déconnexion.

Après stockage du signal vidéo de toute une ligne j de points d'affichage 2 de l'imageur, j étant un entier allant de 1 à m, ce signal vidéo peut être transféré sur les points d'affichage 2 de ladite ligne au moyen du registre à décalage "ligne" comportant m points de registre $6_1$, ...,$6_m$, un point de registre par ligne. Ce registre "ligne" est aussi un registre à écriture série et lecture parallèle. Le transfert est assuré par le point de registre $6_j$ en mettant à l'état conducteur des transistors associés à chacun des points d'affichage 2 de la ligne j.

Après le transfert du signal vidéo sur la ligne j de l'imageur, les mémoires analogiques $4_1$,...,$4_n$ sont vidées puis rechargées avec le signal vidéo de la ligne j+1 suivante. Pendant ce rechargement, le point de registre $6_{j+1}$ est commandé de manière à rendre conducteurs les transistors associés à chacun des points d'affichage de la ligne j+1.

Le registre "ligne" 6 est commandé de manière semblable au registre 5. Le point de registre $6_1$ reçoit un signal 8 composé d'un "1", ledit signal "1" étant transféré par des signaux d'horloge sucessivement dans chaque point de registre $6_2, \ldots, 6_n$, le point de registre $6_j$, où $1 \le j \le m$, rendant conducteurs les transistors associés aux points d'affichage 2 de la ligne j.

Sur la figure 2, on a représenté de façon plus détaillée, un registre à décalage "colonne" $(5_1, \ldots, 5_n)$ conforme à l'art antérieur. Il est à noter qu'un registre à décalage "ligne" $(6_j, \ldots, 6_m)$ est quasi identique au registre "colonne".

Ce registre "ligne" est constitué de points de registre comportant chacun deux points mémoires dynamiques ou bien un point mémoire statique et un point mémoire dynamique. Dans ces points de registre, l'information nécessaire à l'adressage de la colonne i est stockée par exemple, comme représenté sur la figure 2, dans un point mémoire statique $S_i$, formé d'un simple bistable (deux portes bouclées). Pendant le transfert de l'information du point mémoire $S_i$ au point de mémoire $S_{i+1}$, l'information contenue dans le point mémoire statique $S_i$ est stockée temporairement dans un point mémoire dynamique $D_i$ constitué principalement par un condensateur. Le point mémoire dynamique $D_i$ est indispensable car il permet de conserver l'ancienne information contenue dans le point mémoire $S_i$ pendant que l'on modifie le contenu de celui-ci.

Le décalage de l'information du point mémoire $S_i$ au point $S_{i+1}$ et donc d'un point de registre à l'autre, est effectué par l'intermédiaire de commutateurs $C_1$ et $C_2$ dont la fermeture est commandée par, respectivement, des impulsions d'horloge $\varphi_{11}$ et $\varphi_{12}$ déphasées, engendrées par une horloge de transfert 12 ; les impulsions $\varphi_{12}$, commandant les commutateurs

$C_2$, permettent le transfert de l'information des points mémoire $S_i$ aux points mémoire $D_i$ et les impulsions $\varphi_{11}$ commandant les commutateurs $C_1$ permettent le chargement du premier point mémoire $S_i$ puis le transfert de l'information des points mémoires $D_i$ aux points mémoires $S_{i+1}$.

Ces registres à décalage sont relativement encombrants et pour certaines applications, comme par exemple pour l'adressage d'une matrice redondante d'un imageur, il est difficile d'implanter deux ou plusieurs points de registre à décalage dans le pas d'une ligne de commande des points élémentaires d'affichage, ce pas ayant généralement une largeur de 100 µm.

L'invention a justement pour objet un circuit d'adressage d'un imageur matriciel, comportant des registres à décalage simplifiés, et un procédé d'adressage utilisant un circuit permettant de remédier à cet inconvénient.

D'une façon plus précise, l'invention a pour objet un circuit d'adressage de p lignes ou p colonnes de points élémentaires d'affichage d'un imageur matriciel comportant p points de registre à décalage "ligne" ou "colonne" à écriture série et sortie parallèle, des commutateurs intercalés entre les points de registre "ligne" ou "colonne", une première horloge de transfert délivrant des signaux d'horloge commandant les commutateurs pour assurer le décalage d'une information d'un point de registre à l'autre, caractérisé en ce que la première horloge engendre un premier signal d'horloge commandant une première série de commutateurs, un commutateur de ladite première série étant placé avant un point de registre $M_{k-1}$, où k est un nombre pouvant prendre toutes les valeurs paires allant de 1 à p, ledit premier signal d'horloge servant à assurer le chargement d'un signal "1" dans le

B 8066.3 LC

premier point de registre et le transfert du contenu du point de registre $M_k$, au point de registre $M_{k+1}$, en ce que la première horloge engendre un second signal d'horloge de même fréquence que le premier et déphasé par rapport à celui-ci, commandant une seconde série de commutateurs, un commutateur de ladite seconde série étant placé avant un point de registre $M_k$, ledit second signal d'horloge servant à assurer le transfert du contenu du point de registre $M_{k-1}$ au point de registre $M_k$ et en ce que chaque point de registre $M_k$ est formé d'un unique point de mémoire statique.

Le circuit d'adressage selon l'invention comprend un registre à décalage "ligne" et/ou "colonne" comportant deux fois moins de points de mémoire que ceux de l'art antérieur ; ceci permet de diviser par deux l'encombrement de ces registres ainsi que la fréquence de la première horloge de commande des commutateurs. Ceci est notamment dû à l'emploi uniquement de points mémoire statiques.

Dans le cas particulier de l'adressage des lignes de points élémentaires d'affichage de l'imageur, le circuit de l'invention comprend de plus une troisième et une quatrième séries de commutateurs servant au transfert d'un signal vidéo échantillonné dans les points élémentaires d'affichage de l'une des p lignes, les commutateurs de la troisième série étant situés à la sortie des registres $M_{k-1}$ et les commutateurs de la quatrième série étant situés à la sortie des registres $M_k$, ainsi qu'une seconde horloge engendrant un troisième signal d'horloge commandant la troisième série de commutateurs et un quatrième signal d'horloge, de même fréquence que le troisième et déphasé par rapport à celui-ci, commandant la quatrième série de commutateurs.

L'invention a aussi pour objet un procédé

B 8066.3 LC

d'adressage des p lignes ou p colonnes de points élémentaires d'affichage d'un imageur matriciel utilisant le circuit d'adressage caractérisé en ce que l'on effectue les étapes suivantes :

- chargement d'un signal "1" dans le premier point de registre à l'aide du premier signal d'horloge, les autres points de registre contenant un signal "0",

- transfert de ce signal "1" pas à pas d'un point de registre $M_{k-1}$ à un registre $M_k$ à l'aide du second signal d'horloge, ce signal "1" étant disponible en sortie du point $M_{k-1}$, puis d'un point de registre $M_k$ à un point de registre $M_{k+1}$ à l'aide du premier signal d'horloge, le signal "1" étant disponible en sortie du point $M_k$, les points de registre autres que $M_k$ et $M_{k+1}$ contenant un signal "0".

Dans le cas particulier de l'adressage de deux lignes successives de points d'affichage d'un imageur, on effectue avantageusement les étapes supplémentaires suivantes :

- mémorisation d'un premier signal vidéo dans des mémoires analogiques devant être transférées sur la $k-1^{\text{ième}}$ ligne de l'imageur,

- transfert dudit premier signal vidéo des mémoires analogiques sur la $k-1^{\text{ième}}$ ligne à l'aide d'un troisième signal d'horloge commandant un commutateur d'une troisième série de commutateurs, connecté à la sortie du point de registre $M_{k-1}$,

- mémorisation d'un second signal vidéo dans les mémoires analogiques devant être transférées sur la $k^{\text{ième}}$ ligne de l'imageur, et

- transfert dudit second signal vidéo des mémoires analogiques sur la $k^{\text{ième}}$ ligne à l'aide d'un quatrième signal d'horloge de même fréquence que le troisième et déphasé par rapport à celui-ci, commandant un commutateur d'une quatrième série de commutateurs connectés à la sortie du point de registre $M_k$.

D'autres avantages et caractéristiques de l'invention ressortiront mieux de la description qui va suivre, donnée en référence aux dessins annexés, dans lesquels :

- la figure 1, déjà décrite, représente schématiquement et de façon simplifiée un imageur matriciel, équipé de ses circuits de commande conformes à l'art antérieur,

- la figure 2, déjà décrite, représente schématiquement un registre à décalage ligne selon l'art antérieur,

- la figure 3 représente schématiquement un registre à décalage "colonne" selon l'invention,

- la figure 4 représente un diagramme montrant les états des points de registre "colonne" au cours du temps,

- la figure 5 représente schématiquement un registre à décalage "ligne" selon l'invention, et

- la figure 6 représente un diagramme montrant les états des points de registre "ligne" au cours du temps.

La description qui va suivre est faite pour un imageur matriciel comportant n colonnes et m lignes de points d'affichage élémentaires.

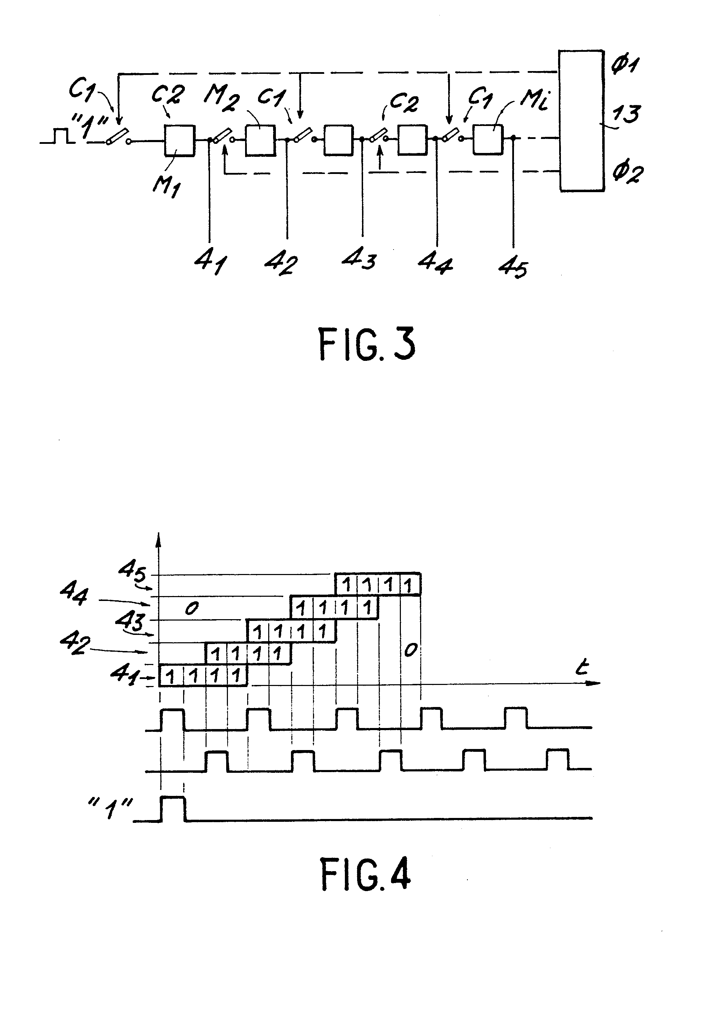

Sur la figure 3, on a représenté un registre à décalage "colonne" permettant l'adressage des points d'affichage élémentaires des colonnes de l'imageur.

Selon l'invention, le registre "colonne" comprend uniquement n points mémoire statiques $M_1, ... M_n$, soit un seul point mémoire par point de registre. Chaque point mémoire $M_i$, où i est un entier allant de 1 à n, est formé par exemple d'un simple bistable (deux portes bouclées) réalisé selon la technologie MOS.

Entre deux points mémoire consécutifs un

0151077

commutateur $C_1$ ou $C_2$ en alternance est prévu ; la commande de ces commutateurs $C_1$, $C_2$ est assurée respectivement par des signaux d'horloge $\varphi_1$ et $\varphi_2$ engendrés successivement par une horloge de transfert 13.

Le signal d'horloge $_1$ commande simultanément tous les commutateurs $C_1$, ces derniers servant à connecter et déconnecter deux à deux les points mémoire $M_i$ d'indice pair ($M_2$, $M_4$, $M_6$,...) aux points mémoire $M_{i+1}$ d'indice impair ($M_3$, $M_5$, $M_7$,...).

De même, le signal d'horloge $_2$ commande simultanément tous les commutateurs $C_2$, ces derniers servant à connecter et déconnecter deux à deux les points mémoire $M_i$ d'indice impair ($M_1$, $M_3$, $M_5$,...) aux points mémoire $M_{i+1}$ d'indice pair ($M_2$, $M_4$, $M_6$,...).

Les signaux d'horloge $\varphi_1$ et $\varphi_2$ délivrés par l'horloge de transfert 13 ont, pour un registre "colonne" de taille déterminée une fréquence moitié de celle des signaux d'horloge $\varphi_{11}$ et $\varphi_{12}$ délivrés par l'horloge de transfert 12 utilisée dans un registre "colonne" selon l'art antérieur tel que représenté sur la figure 2.

Le fonctionnement de ce registre "colonne" servant à l'échantillonnage du signal vidéo 3 dans les n mémoires analogiques $4_1$,...,$4_n$ (figure 1) va être décrit ci-dessous en détail, en référence à la figure 4 représentant le diagramme des états des points de registre "colonne" au cours du temps.

Comme illustré sur la figure 4, les signaux d'horloge $\varphi_1$ et $\varphi_2$ sont déphasés, notamment de $\pi$, et de même fréquence.

A l'état initial tous les points mémoire $M_i$ sont à l'état "0". Le stockage de la première information d'adressage ou signal "1" dans le point mémoire $M_1$, pour permettre l'échantillonnage du signal vidéo 3

B 8066.3 LC

dans la mémoire analogique $4_1$ (figure 1) est assuré par la première impulsion d'horloge $\varphi_1$.

Le signal "1" stocké dans le point mémoire $M_1$ est ensuite transféré dans le point mémoire $M_2$, grâce à la première impulsion d'horloge $\varphi_2$, tout en étant disponible en sortie du point mémoire $M_1$, pour l'échantillonnage du signal vidéo dans la mémoire analogique $4_1$. Bien que le signal $\varphi_2$ commande simultanément tous les commutateurs $C_2$, seul le contenu du point mémoire $M_2$ est modifié, les autres points mémoire $M_3$, $M_4$, $M_5$,... étant à l'état "0". Le signal "1" stocké dans le point mémoire $M_2$ est ensuite transféré au point mémoire $M_3$, grâce à la seconde impulsion d'horloge $\varphi_1$, tout en étant disponible en sortie du point mémoire $M_2$ pour l'échantillonnage du signal vidéo dans la mémoire analogique $4_2$. Pendant le transfert du signal "1" du point mémoire $M_2$ au point mémoire $M_3$, un signal "0" est introduit dans le point mémoire $M_1$. Bien que le signal $\varphi_1$ commande simultanément tous les commutateurs $C_1$, seul le contenu du point mémoire $M_3$ est modifié, les points $M_4$, $M_5$, $M_6$,... étant à l'état "0". Le décalage de l'information dans les différents points mémoire $M_i$ se poursuit ainsi de suite jusqu'au dernier (i-n), ainsi que l'échantillonnage du signal vidéo correspondant à tout une ligne j de points d'affichage de l'imageur, j étant un entier allant de 1 à m.

Dans le registre à décalage "colonne", on a donc toujours deux "1" (figure 4) dans deux points mémoire successifs $M_i$ et $M_{i+1}$, sauf bien entendu lors du chargement du point mémoire $M_1$ et lors de l'échantillonnage du signal vidéo dans le point mémoire $M_n$.

La présence simultanée d'un "1" dans les points mémoire $M_i$ et $M_{i+1}$ n'est nullement gênante pour l'échantillonnage du signal vidéo dans les mémoires

analogiques $4_i$, étant donné que ces mémoires sont des condensateurs, et donc chargées par la dernière valeur du signal vidéo 3 reçu avec leur déconnexion. A chaque impulsion d'horloge $\varphi_1$ ou $\varphi_2$ (figure 4), une mémoire analogique $4_i$ est déconnectée et par conséquent le signal vidéo correspondant est échantillonné. Dans l'art antérieur (figure 2) le signal vidéo n'est échantillonné que pour les signaux d'horloge $\varphi_{12}$, le signal $\varphi_{11}$ servant uniquement au transfert de l'information d'un point registre à l'autre. De plus, le registre à décalage "colonne" de l'invention contient deux fois moins d'éléments mémoire que celui de l'art antérieur.

Après stockage du signal vidéo de toute une ligne j de points d'affichage élémentaires, j allant de 1 à m, ce signal vidéo peut être transféré sur les points d'affichage de ladite ligne, au moyen du registre à décalage "ligne" de l'invention.

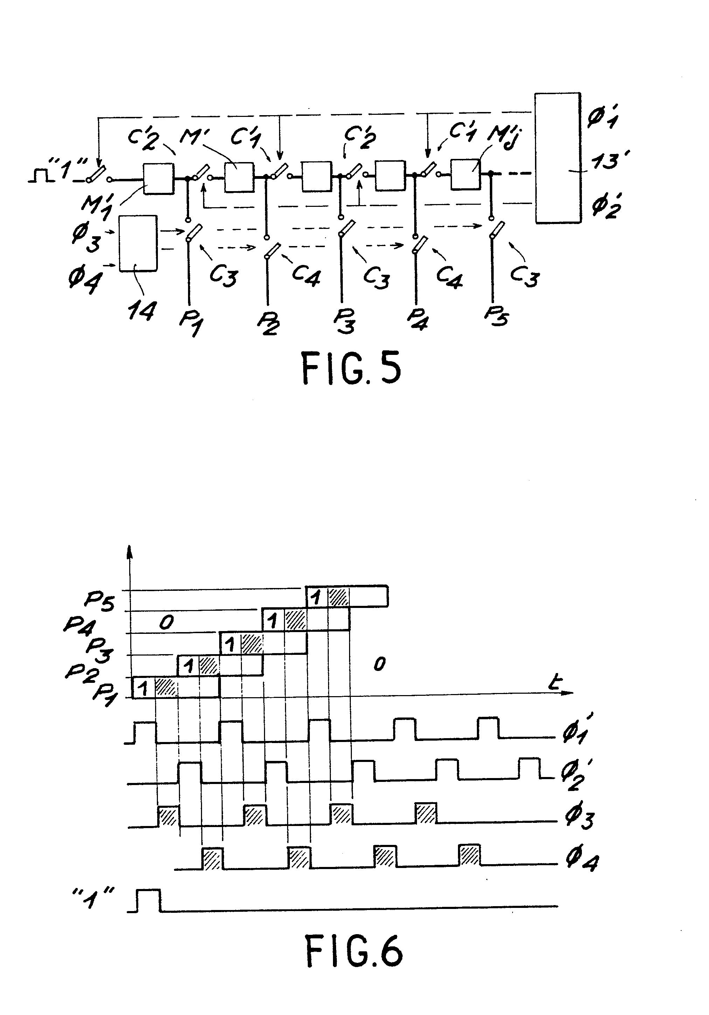

Sur la figure 5, on a représenté un registre à décalage "ligne" conforme à l'invention. Ce registre "ligne" est de même constitution que le registre "colonne" et fonctionne de la même façon que ce dernier ; les éléments jouant le même rôle porteront donc les mêmes références, suivies du symbole "'".

Ce registre "ligne" est formé uniquement de m points mémoires statiques $M'_1, \ldots M'_m$, soit un seul point mémoire par point de registre. Chaque point mémoire $M'_j$, j allant de 1 à m, est formé d'un simple bistable fabriqué selon la technologie MOS.

Entre deux points mémoire consécutifs un commutateur $C'_1$ ou $C'_2$ en alternance est prévu ; la commande simultanée des commutateurs $C'_1$ est assurée par un signal d'horloge $\varphi'_1$ et celle des commutateurs $C'_2$ par un signal d'horloge $\varphi'_2$.

Les signaux $\varphi'_1$ et $\varphi'_2$, engendrés succes-

sivement par une horloge de transfert 13', sont dépha-sés, par exemple de $\pi$, et de même fréquence, comme représenté sur la figure 6.

Comme pour le registre "colonne", la premiè-re impulsion du signal $'_1$ sert à stocker un "1" dans le point mémoire $M'_i$ et les autres impulsions aux transferts réciproquement de ce signal "1" des points mémoire $M'_2$, $M'_4$, $M'_6$,... aux points mémoire $M'_3$, $M'_5$, $M'_7$,...

De même, les impulsions d'horloge $'_2$ servent à transférer un signal "1" réciproquement des points mémoire $M'_1$, $M'_3$, $M'_5$,... aux points mémoire $M'_2$, $M'_4$, $M'_6$,...

Comme précédemment, un seul point mémoire $M'_j$ voit son contenu se modifier lors de l'application du signal $\varphi'_1$ ou $\varphi'_2$.

Comme pour le registre à décalage "colonne", on a toujours deux "1", comme le montre la figure 6, dans deux points mémoire successifs $M'_j$ et $M'_{j+1}$, les autres points mémoire sont à l'état "0". Contrairement au registre "colonne", la présence de ces deux "1" dans le registre "ligne" est gênante ; en effet, le transfert du signal vidéo sur les points d'affichage de l'imageur ne doit intervenir que pour une seule ligne de points d'affichage de l'imageur et non pour deux.

Afin de n'utiliser qu'un seul "1" contenu dans le registre "ligne" on place en sortie de chaque point mémoire $M'_j$ et donc de chaque point de registre "ligne" un commutateur $C_3$ ou $C_4$, en alternance ; la commande de ces commutateurs $C_3$ est assurée respecti-vement par des signaux d'horloge $\varphi_3$ et $\varphi_4$ engendrés successivement par une horloge de transfert 14. Les signaux $\varphi_3$ et $\varphi_4$ sont déphasés et de même fréquence.

Le signal $\varphi_3$ commandant simultanément tous

les commutateurs $C_3$ sert au transfert du signal vidéo correspondant sur les lignes 1, 3, 5, 7 des points d'affichage de l'imageur. De même, le signal $\varphi_4$ commandant simultanément tous les commutateurs $C_4$ sert au transfert du signal vidéo correspondant sur les lignes 2, 4, 6,... des points d'affichage de l'imageur.

Afin de bien transférer le signal vidéo de la ligne j sur ladite ligne, il est nécessaire que les différentes impulsions d'horloge soient appliquées aux différents commutateurs $C'_1$, $C'_2$, $C_3$ et $C_4$ dans l'ordre suivant : $\varphi_1$, $\varphi_3$, $\varphi_2$ et $\varphi_4$.

Le registre à décalage "ligne" de l'invention contient deux fois moins d'éléments mémoire que celui de l'art antérieur.

REVENDICATIONS

1. Circuit d'adressage de p lignes ou p colonnes de points élémentaires d'affichage (2) d'un
imageur matriciel comportant p points de registre à
décalage "ligne" ou "colonne" ($5_i$, $6_j$) à écriture série et sortie parallèle, des commutateurs ($C_1$, $C_2$,
$C'_1$, $C'_2$) intercalés entre les points de registre
"ligne" ou "colonne" ($5_i$, $6_j$), une première horloge de
transfert (13, 13') délivrant des signaux d'horloge
( $\psi_1$, $\psi_2$, $\psi'_1$, $\psi'_2$) commandant les commutateurs pour
assurer le décalage d'une information d'un point de
registre à l'autre, caractérisé en ce que la première
horloge (13, 13') engendre un premier signal d'horloge
( $\psi_1$, $\psi'_1$) commandant une première série de commutateurs ($C_1$, $C'_1$), un commutateur de ladite première série étant placé avant un point de registre $M_{k-1}$, où k
est un nombre pouvant prendre toutes les valeurs paires allant de 1 à p, ledit premier signal d'horloge
servant à assurer le chargement d'un signal "1" dans
le premier point de registre ($M_1$, $M'_1$) et le transfert
du contenu du point de registre $M_k$, au point de registre $M_{k+1}$, en ce que la première horloge engendre un
second signal d'horloge ( $\psi_2$, $\psi'_2$), de même fréquence
que le premier et déphasé par rapport à celui-ci, commandant une seconde série de commutateurs ($C_2$, $C'_2$),
un commutateur de ladite seconde série étant placé
avant un point de registre $M_k$, ledit second signal
d'horloge servant à assurer le transfert du contenu du
point de registre $M_{k-1}$ au point de registre $M_k$ et en
ce que chaque point de registre $M_k$ est formé d'un unique point de mémoire statique ($M_i$, $M'_j$).

2. Circuit d'adressage selon la revendication 1, des p lignes de points élémentaires d'affichage de l'imageur, caractérisé en ce qu'il comprend une
troisième et une quatrième séries de commutateurs ($C_3$,

$C_4$) servant au transfert d'un signal vidéo (3) échantillonné dans les points élémentaires d'affichage de l'une des p lignes, les commutateurs ($C_3$) de la troisième série étant situés à la sortie des registres $M_{k-1}$ et les commutateurs ($C_4$) de la quatrième série étant situés à la sortie des registres $M_k$, et en ce qu'il comprend une seconde horloge (14) engendrant un troisième signal d'horloge ($_3$) commandant la troisième série de commutateurs ($C_3$) et un quatrième signal d'horloge ($\varphi_4$) de même fréquence que le troisième et déphasé par rapport à celui-ci, commandant la quatrième série de commutateurs ($C_4$).

3. Procédé d'adressage des p lignes ou p colonnes de points élémentaires d'affichage d'un imageur matriciel utilisant le circuit d'adressage selon la revendication 1, caractérisé en ce que l'on effectue les étapes suivantes :

- chargement d'un signal "1" dans le premier point de registre ($M_1$, $M'_1$) à l'aide du premier signal d'horloge ($\varphi_1$, $\varphi'_1$), les points de registre autres que $M_k$ et $M_{k+1}$ contenant un signal "0",

- transfert de ce signal "1" pas à pas d'un point de registre $M_{k-1}$ à un registre $M_k$ à l'aide du second signal d'horloge ($\varphi_2$, $\varphi'_2$), ce signal "1" étant disponible en sortie du point $M_{k-1}$, puis d'un point de registre $M_k$ à un point de registre $M_{k+1}$ à l'aide du premier signal d'horloge ($\varphi_1$, $\varphi'_1$), le signal "1" étant disponible en sortie du point $M_k$, les autres points de registre autres que $M_k$ et $M_{k+1}$ contenant un signal "0".

4. Procédé d'adressage selon la revendication 3, de deux lignes successives de points élémentaires d'affichage de l'imageur, caractérisé en ce que l'on effectue les étapes suivantes :

- mémorisation d'un premier signal vidéo (3) dans des mémoires analogiques ($4_1,...,4_n$) devant être transférées sur la $k-1^{ième}$ ligne de l'imageur,

- transfert dudit premier signal vidéo des mémoires analogiques sur la $k-1^{ième}$ ligne à l'aide d'un troisième signal d'horloge ($\varphi_3$) commandant un commutateur ($C_3$) d'une troisième série de commutateurs, connecté à la sortie du point de registre $M_{k-1}$,

- mémorisation d'un second signal vidéo (3) dans les mémoires analogiques ($4_1,...,4_n$) devant être transférées sur la $k^{ième}$ ligne de l'imageur, et

- transfert dudit second signal vidéo des mémoires analogiques sur la $k^{ième}$ ligne à l'aide d'un quatrième signal d'horloge ($\varphi_4$) de même fréquence que le troisième et déphasé par rapport à celui-ci, commandant un commutateur ($C_4$) d'une quatrième série de commutateurs connectés à la sortie du point de registre $M_k$.

1,3

0151077

FIG.1

FIG.2

FIG. 3

FIG.4

FIG.5

FIG.6